# EUROPÄISCHE PATENTSCHRIFT

(11) **EP 0 698 797 B1**
(45) Veröffentlichungstag und Bekanntmachung des Hinweises auf die Patenterteilung: **27.02.2002**
(21) Anmeldenummer: 95111891.8
(22) Anmeldetag: 28.07.1995
(51) Int. Cl.: G01R 33/561

(54) **Verfahren der bildgebenden Kernspintomographie zur simultanen Erzeugung mehrerer Schichtbilder**
Method of nuclear spin tomography for simultaneously generating a plurality of slices in imaging
Procédé de tomographie à spin nucléaire pour la génération simultanée de plusieurs tranches d'images

(30) Priorität: 27.08.1994 DE 4430460
(43) Veröffentlichungstag der Anmeldung: 28.02.1996
(73) Patentinhaber: Hennig, Jürgen, Prof. Dr., D-79100 Freiburg im Breisgau (DE)
(72) Erfinder: Hennig, Jürgen, Prof. Dr., D-79100 Freiburg im Breisgau (DE)
(74) Vertreter: KOHLER SCHMID + PARTNER

(56) Entgegenhaltungen:
- EP-A- 0 259 935
- EP-A- 0 373 747
- EP-A- 0 637 756
- DE-A- 4 216 969
- US-A- 4 577 152
- US-A- 5 237 273
- THE BRITISH JOURNAL OF RADIOLOGY, Bd.66, Nr.792, Dezember 1993, LONDON, UK Seiten 1177 - 1181 S. ZHAO ET AL. 'SIMULTANEOUS MULTISLICE IMAGING WITH AN ADDITIONAL SLICE GRADIENT IN THE READOUT STAGE: AN IDEA FOR MULTISLICE FLASH'

## Beschreibung

Die Erfindung betrifft ein Verfahren zum Erzeugen und Aufnehmen von Kernspinresonanz (NMR)-Signalen in ausgewählten Bereichen eines Untersuchungsobjektes, insbesondere zur Erzeugung von Schnittbildern eines Körpers, bei dem in einem Anregungsschritt in das Untersuchungsobjekt in einem homogenen statischen Magnetfeld als Gradientenecho-Sequenz ein schmalbandiger Hochfrequenz (HF)-Impuls in Anwesenheit eines Schichtselektionsgradienten G_{S} eingestrahlt wird, um ein NMR-Signal in einer ausgewählten Schicht des Untersuchungsobjektes zu erzeugen, und bei dem in einem Aufnahmeschritt in Anwesenheit eines zum Schichtselektionsgradienten G_{S} senkrechten Lesegradienten G_{R} das erzeugte NMR-Signal ausgelesen wird.

Ein solches Verfahren ist beispielsweise bekannt aus DE 35 04 734 A1.

Aus der EP-A-0 259 935 sowie aus der US-A-5 237 273 sind Verfahren zum Erzeugen von NMR-Signalen bekannt, in welchen ein schmalbandiger HF-Impuls in Anwesenheit eines Schichtselektionsgradienten eingestrahlt wird. Die Auslegung erfolgt in Anwesenheit eines zum Schichtselektionsgradienten senkrechten Lesegradienten. Zwischen Anregungsschritt und Aufnahmeschritt werden weitere schmalbandige HF-Impulse jeweils in Anwesenheit eines Schichtselektionsgradienten eingestrahlt, wobei in den Zeitintervallen zwischen dem Einstrahlen der HF-Impulse weitere Gradientenimpulse in Richtung des Lesegradienten geschaltet werden. Die aufeinander folgenden NMR-Signale werden in Anwesenheit eines Lesegradienten ausgelesen. Die bekannten Verfahren machen jedoch nicht von einer Gradientenecho-Sequenz Gebrauch, sondern von Spin-Echo-Sequenzen.

Die Erzeugung von kernspintomographischen Bildern mit Hilfe einer Gradientenechosequenz ist eine in der klinischen Routine häufig verwendete Methode (siehe auch: Higgins Ch, Hricak H, Helms C, Magnetic Resonance Imaging of the Body, Raven Press, New York, 1992, S. 177 ff.). In jüngster Zeit hat sich insbesondere die Anwendung einer solchen Sequenz zur Untersuchung von Signalveränderungen, welche bei Aktivierung kortikaler Areale auftreten, als nützlich herausgestellt (siehe Frahm, J. et al. Magnetic Resonance in Medicine 29: 139, 1993). Aufgrund des hierbei genutzten BOLD-Kontrastmechanismus (siehe Ogawa, S et al. Proc.Natl.Acad.Sci.USA 89:5951, 1992) erfordern diese Untersuchungen eine Signalauslesung mit langen Echozeiten von 40-80 ms. Da die Wiederholzeit der Aufnahme aufeinanderfolgender Einzelprojektionsschritte zwangsläufig größer sein muß als die Signalauslesezeit, ergeben sich hierbei Aufnahmezeiten von ca. 10-20 s pro Bild für eine Aufnahmematrix von 128x256 bis 256x256. Eine Verkürzung dieser Aufnahmezeiten um ca. die Hälfte kann durch sogenanntes Echo-Shifting, bekannt aus Liu G. et al. Proc.XIIth Annual Meeting SMRM, New York, S. 13, 1993) erreicht werden.

Aufgabe der vorliegenden Erfindung ist es demgegenüber, ein Verfahren der eingangs beschriebenen Art vorzustellen, bei dem die Gesamtaufnahmezeit noch wesentlich weiter reduziert werden kann.

Erfindungsgemäß wird diese Aufgabe auf überraschend einfache, aber wirkungsvolle Art und Weise dadurch gelöst, daß in einem Zeitintervall zwischen dem Anregungsschritt und dem Aufnahmeschritt weitere schmalbandige HF-Impulse jeweils in Anwesenheit eines Schichtselektionsgradienten G_{S} eingestrahlt werden, wobei in den Zeitintervallen zwischen dem Einstrahlen der HF-Impulse weitere Gradientenimpulse in Richtung des Lesegradienten G_{R} geschaltet werden, und daß die dadurch erzeugten weiteren, aufeinanderfolgenden NMR-Signale in Anwesenheit des Lesegradienten G_{R} zeitlich versetzt ausgelesen werden.

Eine gängige Methode der Scheibenselektion in der Kernspintomographie besteht darin, daß für die Anregung von Spins in unterschiedlichen Schichten eine entsprechende Wahl von unterschiedlichen Frequenzen der eingestrahlten schmalbandigen HF-Impulse getroffen wird.

Besonders bevorzugt ist eine Variante des erfindungsgemäßen Verfahrens, bei der in einem Zeitintervall zwischen dem Einstrahlen des letzten HF-Impulses und dem Auftreten des ersten erzeugten NMR-Signales ein zum Lesegradienten G_{R} senkrechter Phasencodiergradient G_{P} angelegt wird, und bei der das gesamte Verfahren mehrmals wiederholt wird, wobei jeweils unterschiedliche Phasencodiergradienten G_{P} angelegt werden. Dadurch werden die erzeugten NMR-Signale von einem Durchlauf des Verfahrens zum nächsten einer unterschiedlichen Phasencodierung unterworfen.

Bei einer weiteren bevorzugten Variante des erfindungsgemäßen Verfahrens wird die Stärke der Gradienten so gewählt, daß die NMR-Signale aus unterschiedlichen Schichten des Untersuchungsobjektes bezüglich ihres jeweiligen Anregungs-HF-Impulses jeweils dieselbe Echozeit aufweisen. Durch die äquidistante zeitliche Abfolge der NMR-Signale vereinfacht sich das Aufnahme- und Auswerteverfahren erheblich.

Bei einer vorteilhaften Weiterbildung des erfindungsgemäßen Verfahrens wird ein weiterer Phasencodiergradient in Richtung des Schichtselektionsgradienten G_{S} angelegt und bei Wiederholungen des Verfahrens nach dem Prinzip der drei-dimensionalen Fouriertransformation variiert. Dadurch kann die räumliche Auflösung der NMR-Signale innerhalb jeder Schicht weiter erhöht werden.

Eine Variante des erfindungsgemäßen Verfahrens zeichnet sich dadurch aus, daß die von den HF-Impulsen jeweils in Anwesenheit eines Schichtselektionsgradienten G_{S} erfaßten Volumina des Untersuchungsobjekts identisch sind, so daß die zeitlich versetzt auftretenden NMR-Signale aufgrund der schichtselektiven Anregungen mit HF-Impulsen jeweils aus derselben Schicht des Untersuchungsobjekts stammen.

Es ist daher nicht unbedingt notwendig, das erfindungsgemäße Verfahren ausschließlich zur Erzeugung von Mehrschicht-NMR-Aufnahmen zu verwenden.

Möglich ist eine Verfahrensvariante, bei der die zeitlich versetzt auftretenden NMR-Signale einer beobachteten ausgewählten Schicht jeweils unterschiedlich phasencodiert werden. Bei n auftretenden Signalen wird damit eine Reduktion der Zahl der Aufnahmeschritte um den Faktor n erreicht, so daß bereits im Einzelschichtverfahren eine ganz erhebliche Reduzierung der Meßzeit möglich wird.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine erfindungsgemäße Gradientenechosequenz zur simultanen Auslesung der NMR-Signale mehrerer Schichten;
- Fig. 2: eine Gradientenechosequenz nach dem Stand der Technik;
- Fig. 3: ein Diagramm der zeitlichen Entwicklung der Phase ρ eines Spinsystems in Anwesenheit eines zeitlich veränderlichen Lesegradienten G_{R} bei Anwendung von Anregungs-HF-Impulsen mit Flipwinkeln α; und
- Fig. 4: eine erfindungsgemäße Sequenz zur Erzeugung mehrerer unterschiedlich phasencodierter Signale derselben Schicht.

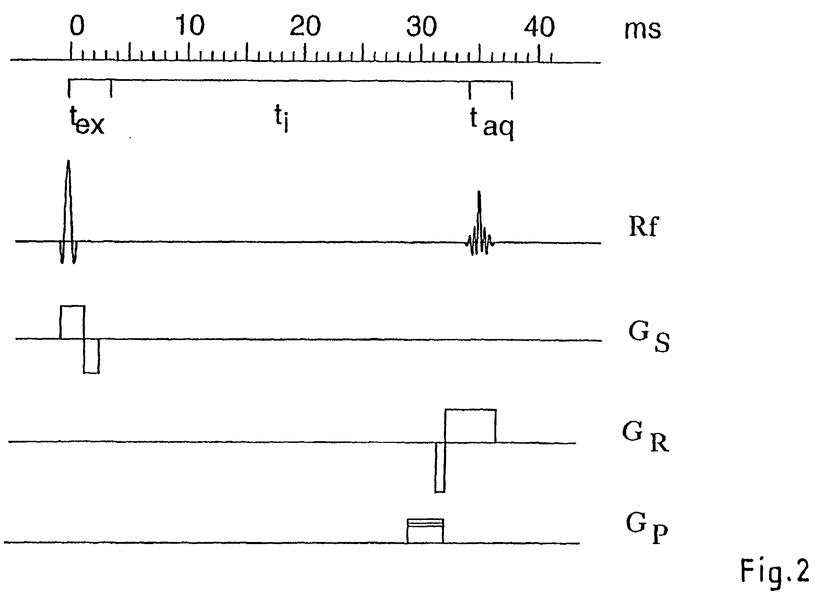

Bei der in Fig. 2 gezeigten bekannten Gradientenechosequenz entspricht G_{S} dem Schichtselektionsgradienten, G_{R} dem Lesegradienten und Gₚ dem Phasencodiergradienten, während Rf den anregenden Hochfrequenzimpuls sowie das dadurch erzeugte NMR-Signal kennzeichnet. Für ein typisches Experiment mit einer Echozeit von 35 ms sind das Schichtselektionsintervall tₑₓ, das Ausleseintervall t_{aq} und die dazwischenliegende Zeit tᵢ angegeben.

Das Grundprinzip des erfindungsgemäßen Verfahrens beruht auf der Erkenntnis, daß für die angestrebte Anwendung der bekannten NMR-Gradientenechosequenz nach Fig. 2 mit langer Echozeit ein langes Zeitintervall tᵢ zwischen der Erzeugung der NMR-Signale durch einen schichtselektiven Hochfrequenzimpuls in Anwesenheit eines Schichtselektionsgradienten G_{S} und der Signalauslesung als Gradientenecho durch Inversion eines Lesegradienten G_{R} auftritt.

Dieses Zeitintervall tᵢ wird im erfindungsgemäßen Verfahren durch weitere Anregungsschritte der beschriebenen Art aufgefüllt, wobei diese weiteren Anregungsschritte im allgemeinen Fall jeweils unterschiedliche Schichten erfassen. Durch Hinzufügen von Gradienten in Richtung des Lesegradienten G_{R} lassen sich die durch die unterschiedlichen Anregungsimpulse hervorgerufenen NMR-Signale während der Ausleseperiode zeitlich aufeinanderfolgend aufnehmen, wobei bei geeigneter Wahl der Stärke dieses zusätzlichen Gradienten jedes NMR-Signal die gleiche Echozeit bezüglich seines Anregungsimpulses aufzeigt.

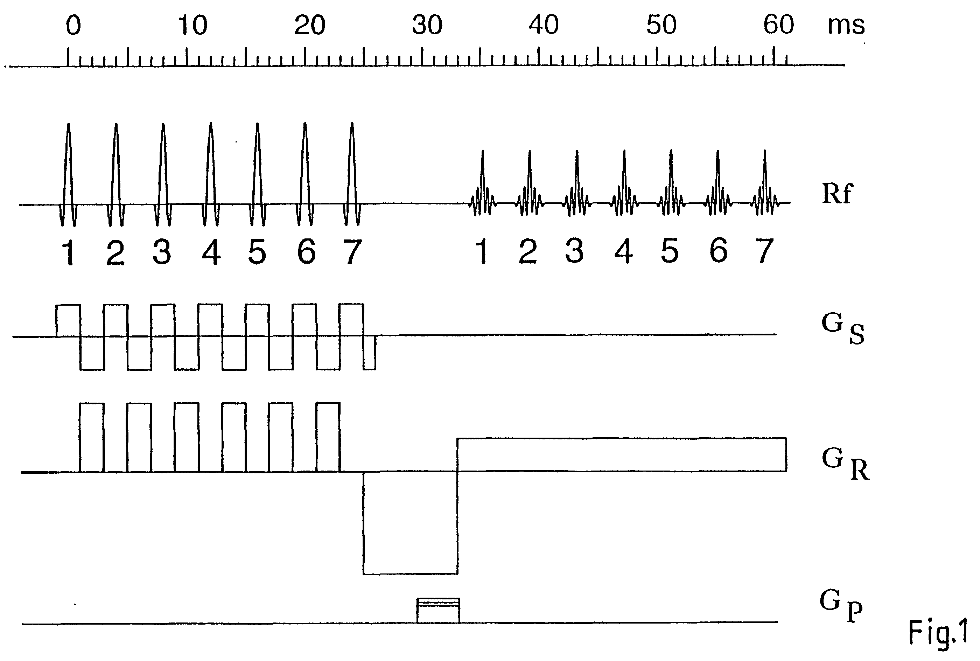

Die in Fig. 1 unter den HF-Impulsen bzw. den NMR-Signalen angegebenen Zahlen ordnen die NMR-Signale den jeweils zugehörigen Selektionsimpulsen zu.

Die Zahl der bei einer vorgegebenen Echozeit tₑ im Intervall anwendbaren Anregungsschritte hängt von der Dauer eines Anregungsintervalls tₑₓ sowie der eines Ausleseschrittes t_{aq} ab. Für übliche Gradientensysteme mit Schaltzeiten unter 1 ms bei Stärken von über 10 mT/m lassen sich ohne weiteres Werte von tₑₓ = 4 ms und t_{aq} = 4 ms erreichen, wie in Fig. 1 gezeigt ist. Damit ist es möglich, bei einer Echozeit von 35 ms 7 Schichten im Meßintervall unterzubringen, Aufgrund der zeitlich aufeinanderfolgenden Auslesung der NMR-Signale verlängert sich die minimale Wiederholzeit im angeführten Beispiel von ca. 40 ms auf ca. 60 ms. Der Zeitgewinn beträgt daher gegenüber einer sequentiellen Aufnahme der Einzelschichten oder gegenüber einer verschachtelten Aufnahme nach dem Multislice-Prinzip etwa einen Faktor 4,7.

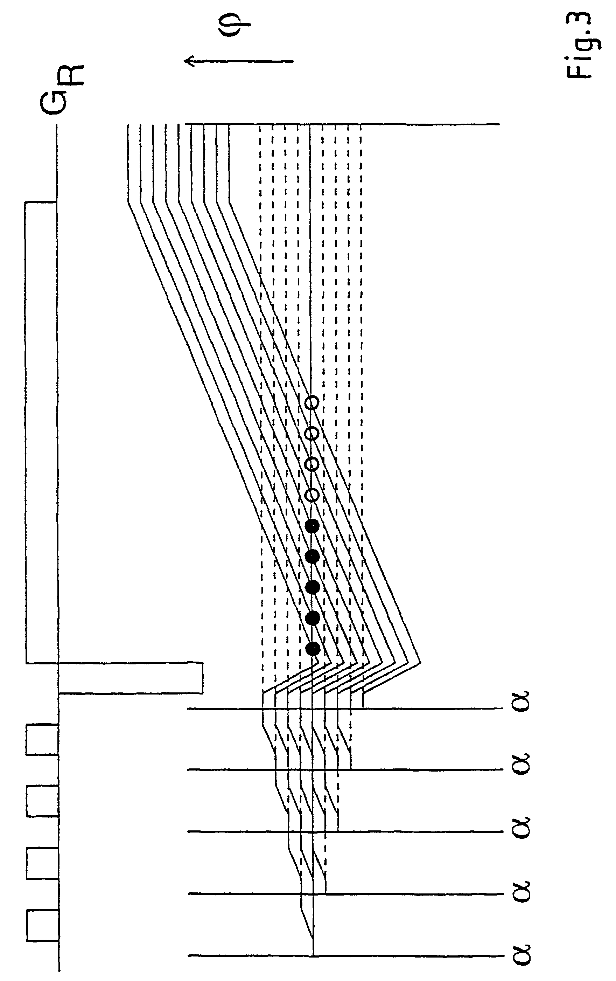

Die erfindungsgemäße Sequenz läßt sich auch dann anwenden, wenn die in Fig. 1 dargestellten einzelnen Anregungsschritte jeweils dieselbe Schicht betreffen. In diesem Fall ist zu berücksichtigen, daß die zeitlich aufeinanderfolgenden NMR-Signale nicht nur als reine Gradientenechos zu betrachten sind, sondern auch Spin-echo- oder stimulierte Echo-Signale durch die Auswirkung zweier oder mehrerer der aufeinanderfolgenden Anregungsimpulse zu berücksichtigen sind. Wie in Fig. 3 aufgezeigt ist, überlagern sich bei dem in Fig. 1 gezeigten Anwendungsschema die jeweiligen NMR-Signalanteile jeweils kohärent, so daß artefaktfreie Bilder entstehen.

Im einzelnen zeigt Fig. 3 die Entwicklungsphase ρ eines Spinsystems in Anwesenheit eines zeitlich veränderlichen Lesegradienten G_{R} bei Anwendung von insgesamt fünf durch senkrechte Striche dargestellten Anregungsimpulsen mit Flipwinkel α. Neben den Gradientenechosignalen (ausgefüllte Kreise), die auch bei Verwendung von Anregungsimpulsen auftreten, mit denen unterschiedliche Schichten ausgewählt werden, ergeben sich hierbei auch die mit offenen Kreisen gekennzeichneten Spinecho-NMR-Signale.

Eine besonders bevorzugte Anwendung dieser Implementierung der Sequenz besteht darin, jedes der auftretenden NMR-Einzelsignale mit unterschiedlicher Phasencodierung zu versehen, so daß hiermit bereits im Einzelschichtverfahren eine Reduzierung der Meßzeit um den oben angegebenen Faktor möglich ist.

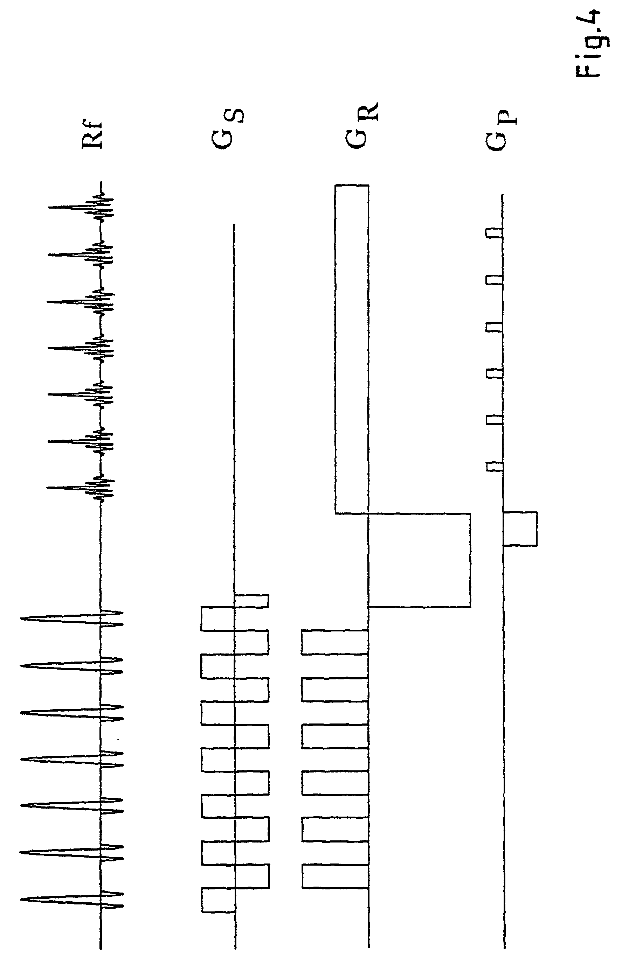

Eine derartige Sequenz zur Erzeugung mehrerer unterschiedlich phasencodierter Signale derselben Schicht ist in Fig. 4 gezeigt.

## Patentansprüche

1. Verfahren zum Erzeugen und Aufnehmen von Kernspinresonanz (NMR)-Signalen in ausgewählten Bereichen eines Untersuchungsobjektes, insbesondere zur Erzeugung von Schnittbildern eines Körpers, bei dem in einem Anregungsschritt in das Untersuchungsobjekt in einem homogenen statischen Magnetfeld als Gradientenecho-Sequenz ein schmalbandiger Hochfrequenz (HF)-Impuls in Anwesenheit eines Schichtselektionsgradienten G_{S} eingestrahlt wird, um ein NMR-Signal in einer ausgewählten Schicht des Untersuchungsobjektes zu erzeugen, und bei dem in einem Aufnahmeschritt in Anwesenheit eines zum Schichtselektionsgradienten G_{S} senkrechten Lesegradienten G_{R} das erzeugte NMR-Signal ausgelesen wird,
**dadurch gekennzeichnet,**
**daß** in einem Zeitintervall zwischen dem Anregungsschritt und dem Aufnahmeschritt weitere schmalbandige HF-Impulse jeweils in Anwesenheit eines Schichtselektionsgradienten G_{S} eingestrahlt werden, wobei in den Zeitintervallen zwischen dem Einstrahlen der HF-Impulse weitere Gradientenimpulse in Richtung des Lesegradienten G_{R} geschaltet werden, und daß die dadurch erzeugten weiteren, aufeinander folgenden NMR-Signale in Anwesenheit des Lesegradienten G_{R} zeitlich versetzt ausgelesen werden.

2. Verfahren nach Anspruch 1, **dadurch gekennzeichnet, daß** in einem Zeitintervall zwischen dem Einstrahlen des letzten HF-Impulses und dem Auftreten des ersten erzeugten NMR-Signals ein zum Lesegradienten G_{R} senkrechter Phasenkodiergradient Gₚ angelegt wird, und daß das gesamte Verfahren mehrmals wiederholt wird, wobei jeweils unterschiedliche Phasencodiergradienten G_{P} angelegt werden.

3. Verfahren nach Anspruch 1 oder 2, **dadurch gekennzeichnet, daß** die Stärke der Gradienten so gewählt wird, daß die NMR-Signale aus unterschiedlichen Schichten des Untersuchungsobjektes bezüglich ihres jeweiligen Anregungs-HF-Impulses jeweils dieselbe Echozeit aufweisen.

4. Verfahren nach Anspruch 2 und/oder 3, **dadurch gekennzeichnet, daß** ein weiterer Phasenkodiergradient in Richtung des Schichtselektionsgradienten G_{S} angelegt und bei Wiederholungen des Verfahrens nach dem Prinzip drei-dimensionalen Fouriertransformation variiert wird.

5. Verfahren nach einem der vorhergehenden Ansprüche, **dadurch gekennzeichnet, daß** die von den HF-Impulsen jeweils in Anwesenheit eines Schichtselektionsgradienten G_{S} erfaßten Volumina des Untersuchungsobjekts identisch sind, so daß die zeitlich versetzt auftretenden NMR-Signale aufgrund der schichtselektiven Anregungen mit HF-Impulsen jeweils aus derselben Schicht des Untersuchungsobjekts stammen.

6. Verfahren nach Anspruch 5, **dadurch gekennzeichnet, daß** die zeitlich versetzt auftretenden NMR-Signale einer beobachteten ausgewählten Schicht jeweils unterschiedlich phasencodiert werden.

## Claims

1. Method for generating and recording nuclear magnetic resonance (NMR) signals in predetermined regions of an object of investigation, in particular for generating slice images of a body, whereby, in an excitation step, a narrow band radio frequency (RF) pulse is irradiated, as a gradient echo sequence, into the object of investigation in a homogeneous static magnetic field in the presence of a slice selection gradient G_{S} in order to generate an NMR signal in a selected slice of the object of investigation, and whereby, in a recording step, the generated NMR signal is read-out in the presence of a read gradient G_{R} which is perpendicular to the slice selection gradient G_{S},
**characterized in that**
in a time interval between the excitation step and the recording step, further narrow band RF pulses are each irradiated in the presence of a slice selection gradient G_{S} whereby, in the time intervals between the irradiation of the RF pulses, additional gradient pulses are switched in the direction of the read gradient G_{R} and that the additional sequential NMR signals thereby produced are read-out in a time displaced fashion in the presence of the read gradient G_{R}.

2. Method according to claim 1, **characterized in that**, in a time interval between irradiation of the last RF pulse and the occurrence of the first generated NMR signal, a phase encoding gradient G_{P}, perpendicular to the read gradient G_{R}, is applied and that the entire procedure is repeated a plurality of times with differing phase encoding gradients G_{P} being applied in each case.

3. Method according to claim 1 or 2, **characterized in that** the strength of the gradients is chosen in such a fashion that the NMR signals from differing slices of the object of investigation each exhibit the same echo time with respect to their corresponding RF excitation pulse.

4. Method according to claim 2 and/or claim 3, **characterized in that** an additional phase encoding gradient is applied in the direction of the slice selection gradient G_{S} and varied under repetition of the method according to the principle of three dimensional Fourier transformation.

5. Method according to one of the preceding claims, **characterized in that** the volumes of the object of investigation covered by the RF pulses, each in the presence of a slice selection gradient G_{S}, are identical so that the time displaced NMR signals come, due to the slice selective excitations with RF pulses, in each case from the same slice of the object of investigation.

6. Method according to claim 5, **characterized in that** the NMR signals of a chosen observed slice occurring in a time displaced fashion are each phase-encoded in a different way.

## Revendications

1. Procédé permettant de générer et enregistrer des signaux de résonance magnétique nucléaire (RMN) dans des zones sélectionnées d'un objet d'examen, en particulier de générer des images en coupe d'un corps, lors duquel, dans une phase d'excitation, une impulsion à haute fréquence (HF) à bande étroite est envoyée dans l'objet d'examen soumis à un champ magnétique statique homogène sous la forme d'une séquence d'écho de gradient en présence d'un gradient de sélection de couche Gₛ afin de générer un signal de RMN dans une couche sélectionnée de l'objet d'examen ; et lors duquel, dans une phase d'enregistrement, le signal de RMN généré est lu en présence d'un gradient de lecture G_{R} perpendiculaire au gradient de sélection de couche G_{S},
**caractérisé par le fait**
**que**, dans un intervalle de temps compris entre la phase d'excitation et la phase d'enregistrement, d'autres impulsions HF à bande étroite sont envoyées en présence chaque fois d'un gradient de sélection de couche G_{S} tandis que, dans les intervalles de temps séparant l'envoi des impulsions HF, d'autres impulsions de gradient sont produites en direction du gradient de lecture, et que les autres signaux de RMN successifs ainsi générés sont lus avec un décalage dans le temps en présence du gradient de lecture G_{R}.

2. Procédé selon la revendication 1, **caractérisé par le fait qu'**un gradient de codage de phase G_{P} perpendiculaire au gradient de lecture G_{R} est appliqué dans un intervalle de temps compris entre l'envoi de la dernière impulsion HF et l'arrivée du premier signal de RMN généré, et que tout le procédé est répété à plusieurs reprises, des gradients de codage de phase G_{P} chaque fois différents étant appliqués.

3. Procédé selon la revendication 1 ou 2, **caractérisé par le fait que** l'intensité des gradients est choisie de telle sorte que les signaux de RMN issus de différentes couches de l'objet d'examen présentent la même durée d'écho par rapport à leurs impulsions HF d'excitation respectives.

4. Procédé selon la revendication 2 et/ou 3, **caractérisé par le fait qu'**un autre gradient de codage de phase est appliqué en direction du gradient de sélection de couche G_{S} et modulé lors des répétitions du procédé selon le principe de la transformée de Fourier à trois dimensions.

5. Procédé selon l'une des revendications précédentes, **caractérisé par le fait que** les volumes de l'objet d'examen acquis par les impulsions HF en présence d'un gradient de sélection de couche Gₛ sont identiques, de sorte que les signaux de RMN arrivant avec un décalage temporel proviennent chaque fois de la même couche de l'objet d'examen du fait des excitations sélectives de couches au moyen d'impulsions HF.

6. Procédé selon la revendication 5, **caractérisé par le fait que** les signaux de RMN arrivant avec un décalage temporel d'une couche sélectionnée observée subissent chacun un codage de phase différent.
